# EUROPEAN PATENT APPLICATION

(11) **EP 4 578 717 A1**
(43) Date of publication of application: **02.07.2025**
(21) Application number: 24217074.4
(22) Date of filing: 03.12.2024
(51) Int. Cl.: B60L 53/22, B60L 53/24, B60L 58/20, G01R 31/52

(54) **ELECTRIC CIRCUIT AND NON-TRANSITORY STORAGE MEDIUM**

(30) Priority: 19.12.2023 JP 2023213908
(71) Applicant: TOYOTA JIDOSHA KABUSHIKI KAISHA, Aichi-ken, 471-8571 (JP)
(72) Inventor: KIM, Jinwoo, TOYOTA-SHI, AICHI-KEN, 471-8571 (JP); KURIBARA, Fumiyoshi, TOYOTA-SHI, AICHI-KEN, 471-8571 (JP); MURASE, Fumitoshi, TOYOTA-SHI, AICHI-KEN, 471-8571 (JP)
(74) Representative: Cabinet Beau de Loménie

(57) **Abstract**

An electric circuit (10) mounted on a vehicle includes: a first battery (11); a second battery (12); a three-phase motor (40); an inverter circuit (30); a charging port (70); a first relay switch (86); a second relay switch (85); a third relay switch (87); and a control circuit (90). The first relay switch (86) is provided between a high potential wire (31) and a high potential charging terminal. The second relay switch (85) is provided between a low potential wire (32) and a low potential charging terminal. The third relay switch (87) is provided between a positive electrode of the second battery (12) and a neutral point (46). The control circuit (90) is configured to turn OFF the third relay switch (87) and then turn OFF the first relay switch (86) and the second relay switch (85) when a charging operation is to be ended.

## Description

### BACKGROUND OF THE INVENTION

### 1. Field of the Invention

The present disclosure relates to an electric circuit and a non-transitory storage medium.

### 2. Description of Related Art

Japanese Unexamined Patent Application Publication No. 2020-120566 discloses an electric circuit mounted on a vehicle. The electric circuit has a series circuit of two batteries, an inverter circuit, and a three-phase motor. The inverter circuit drives the three-phase motor by converting DC electricity supplied from the series circuit of the batteries to AC electricity and supplying the AC electricity to the three-phase motor. The electric circuit has a wire that connects a connection point between the two batteries and a neutral point of each coil of the three-phase motor. The temperature of each battery can be raised by transferring electricity between the two batteries via the wire.

### SUMMARY OF THE INVENTION

There is a technology of charging each battery in an electric circuit having two batteries, an inverter circuit, and a three-phase motor with use of charging equipment outside a vehicle. One battery is connected to the charging equipment via a wire. The other battery is connected to the charging equipment via the inverter circuit and the three-phase motor. According to this configuration, the two batteries can be charged in parallel. This type of electric circuit has a relay switch, and the relay switch is turned OFF when the charging processing ends. The present disclosure discloses an electric circuit and a non-transitory storage medium that reduce deterioration of the relay switch.

An electric circuit according to a first aspect of the present disclosure is mounted on a vehicle. The electric circuit includes: a first battery; a second battery; a three-phase motor; an inverter circuit; a charging port; a first relay switch; a second relay switch; a third relay switch; and a control circuit. The three-phase motor has three windings that are a U-phase winding, a V-phase winding, and a W-phase winding. The three windings each have a first connection terminal provided on one end of the winding and a second connection terminal provided on another end of the winding. The second connection terminals of the three windings are connected to each other at a neutral point. The inverter circuit is connected to the first connection terminal of the U-phase winding, the first connection terminal of the V-phase winding, and the first connection terminal of the W-phase winding and has a high potential wire, a low potential wire, and three series switch circuits respectively provided for the three windings. The three series switch circuits each have an upper-side reverse conducting switching element that is a reverse conducting switching element connected between the high potential wire and the first connection terminal of the corresponding winding, and a lower-side reverse conducting switching element that is a reverse conducting switching element connected between the low potential wire and the first connection terminal of the corresponding winding. The charging port has a high potential charging terminal and a low potential charging terminal and is connected to charging equipment outside the vehicle. The first relay switch is provided between the high potential wire and the high potential charging terminal. The second relay switch is provided between the low potential wire and the low potential charging terminal. The third relay switch is provided between a positive electrode of the second battery and the neutral point. The control circuit is configured to execute a charging operation of controlling the first relay switch, the second relay switch, and the third relay switch to be turned ON, controlling the three lower-side reverse conducting switching elements to be turned OFF, and continuously or intermittently turning ON a specified upper-side reverse conducting switching element that is at least one of the three upper-side reverse conducting switching elements in a state in which the high potential wire is connected to a positive electrode of the first battery and the low potential wire is connected to a negative electrode of the first battery and a negative electrode of the second battery when the first battery and the second battery are charged by the charging port. The control circuit is configured to turn OFF the third relay switch and then turn OFF the first relay switch and the second relay switch when the charging operation is to be ended.

In the electric circuit according to the first aspect of the present disclosure, the control circuit may be configured to turn OFF the specified upper-side reverse conducting switching element and then turn OFF the third relay switch when the charging operation is to be ended.

In the electric circuit according to the first aspect of the present disclosure, the control circuit may be configured to detect a leakage current that flows from the positive electrode of the second battery to the positive electrode of the first battery via the neutral point after the specified upper-side reverse conducting switching element is turned OFF and to turn OFF the third relay switch when the leakage current is smaller than a reference value.

In the electric circuit according to the first aspect of the present disclosure, the control circuit may be configured to raise a current supplied from the charging equipment outside the vehicle to the charging port until a leakage current that flows from the positive electrode of the second battery to the positive electrode of the first battery via the neutral point becomes smaller than a reference value after the specified upper-side reverse conducting switching element is turned OFF, and to turn OFF the third relay switch when the leakage current is smaller than the reference value.

In the electric circuit according to the first aspect of the present disclosure, the control circuit may be configured to execute fixation determination processing of detecting a current that flows to the second battery in a state in which the specified upper-side reverse conducting switching element is turned ON and a state in which the specified upper-side reverse conducting switching element is turned OFF after a signal that turns OFF the third relay switch is output.

A non-transitory storage medium according to the second aspect of the present disclosure stores instructions that are executable by one or more processors and causes the one or more processors to perform functions below. The functions include causing an electric circuit mounted on a vehicle to execute charging processing. The electric circuit includes: a first battery; a second battery; a three-phase motor; an inverter circuit; a charging port; a first relay switch; a second relay switch; a third relay switch; and a control circuit. The three-phase motor has three windings that are a U-phase winding, a V-phase winding, and a W-phase winding. The three windings each have a first connection terminal provided on one end of the winding and a second connection terminal provided on another end of the winding. The second connection terminals of the three windings are connected to each other at a neutral point. The inverter circuit is connected to the first connection terminal of the U-phase winding, the first connection terminal of the V-phase winding, and the first connection terminal of the W-phase winding and has a high potential wire, a low potential wire, and three series switch circuits respectively provided for the three windings. The series switch circuits each have an upper-side reverse conducting switching element that is a reverse conducting switching element connected between the high potential wire and the first connection terminal of the corresponding winding, and a lower-side reverse conducting switching element that is a reverse conducting switching element connected between the low potential wire and the first connection terminal of the corresponding winding. The charging port has a high potential charging terminal and a low potential charging terminal and is connected to charging equipment outside the vehicle. The first relay switch is provided between the high potential wire and the high potential charging terminal. The second relay switch is provided between the low potential wire and the low potential charging terminal. The third relay switch is provided between a positive electrode of the second battery and the neutral point. The functions include causing the control circuit to execute a charging operation. The charging operation is an operation of controlling the first relay switch, the second relay switch, and the third relay switch to be turned ON, controlling the three lower-side reverse conducting switching elements to be turned OFF, and continuously or intermittently turning ON a specified upper-side reverse conducting switching element that is at least one of the three upper-side reverse conducting switching elements in a state in which the high potential wire is connected to a positive electrode of the first battery and the low potential wire is connected to a negative electrode of the first battery and a negative electrode of the second battery when the first battery and the second battery are charged by the charging port. The functions include causing the control circuit to turn OFF the third relay switch and then to turn OFF the first relay switch and the second relay switch when the charging operation is to be ended.

In the present specification, the reverse conducting switching element means an element in which a switching element and a diode are connected in parallel to each other and an element in which a cathode of the diode is connected to a high-potential-side terminal of the switching element and an anode of the diode is connected to a low-potential-side terminal of the switching element. The switching element may be a semiconductor switching element such as a field effect transistor and an insulated gate bipolar transistor. The diode may be a pn diode or a Schottky barrier diode. The switching element and the diode may be provided on a common semiconductor substrate or may be provided on different semiconductor substrates. In the present specification, turning ON of the reverse conducting switching element means turning ON of the switching element included in the reverse conducting switching element, and turning OFF of the reverse conducting switching element means turning OFF of the switching element included in the reverse conducting switching element.

The electric circuit of the present disclosure turns OFF the third relay switch and then turns OFF the first relay switch and the second relay switch when the charging operation is to be ended. According to this configuration, it becomes possible to reduce the deterioration of the first relay switch and the second relay switch.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a circuit diagram of an electric circuit of an embodiment and is a diagram showing a charging route for a first battery;
FIG. 2 is a circuit diagram of the electric circuit of the embodiment and is a diagram showing a charging route for a second battery in a state in which an upper-side reverse conducting switching element is turned ON;
FIG. 3 is a circuit diagram of the electric circuit of the embodiment and is a diagram showing a charging route for the second battery in a state in which the upper-side reverse conducting switching element is turned OFF;
FIG. 4 is a flowchart showing charging end processing of Embodiment 1;
FIG. 5 is a circuit diagram of the electric circuit of the embodiment and is a diagram showing a route of a leakage current 11;
FIG. 6 is a flowchart showing charging end processing of Embodiment 2; and
FIG. 7 is a flowchart showing charging end processing of Embodiment 3.

### DETAILED DESCRIPTION OF EMBODIMENTS

In first electric circuit, in one example, the control circuit may turn OFF the specified upper-side reverse conducting switching element and then turn OFF the third relay switch when the charging operation is to be ended.

According to this configuration, the deterioration of the third relay switch can be reduced.

In the first electric circuit, in one example, the control circuit may detect a leakage current that flows from the positive electrode of the second battery to the positive electrode of the first battery via the neutral point after the specified upper-side reverse conducting switching element is turned OFF and turn OFF the third relay switch when the leakage current is smaller than a reference value.

According to this configuration, the deterioration of the third relay switch can be reduced more effectively.

In the first electric circuit, in one example, the control circuit may raise a current supply to the charging port until a leakage current that flows from the positive electrode of the second battery to the positive electrode of the first battery via the neutral point becomes smaller than a reference value after the specified upper-side reverse conducting switching element is turned OFF, and turn OFF the third relay switch when the leakage current is smaller than the reference value.

According to this configuration, the deterioration of the third relay switch can be reduced more effectively.

In the first electric circuit, in one example, the control circuit may execute fixation determination processing of detecting a current that flows to the second battery in a state in which the specified upper-side reverse conducting switching element is turned ON and a state in which the specified upper-side reverse conducting switching element is turned OFF after a signal that turns OFF the third relay switch is output.

According to this configuration, fixation of the third relay switch can be detected.

A second electric circuit disclosed in the present specification is mounted on a vehicle. The electric circuit has: a first battery; a second battery; a three-phase motor; an inverter circuit; a charging port; a first relay switch; a second relay switch; a third relay switch; and a control circuit. The three-phase motor has three windings that are a U-phase winding, a V-phase winding, and a W-phase winding. The three windings each have a first connection terminal provided on one end of the winding and a second connection terminal provided on another end of the winding. The second connection terminals of the three windings are connected to each other at a neutral point. The inverter circuit is connected to the first connection terminal of the U-phase winding, the first connection terminal of the V-phase winding, and the first connection terminal of the W-phase winding. The charging port has a high potential charging terminal and a low potential charging terminal and is connected to charging equipment outside the vehicle. The inverter circuit has a high potential wire, a low potential wire, and three series switch circuits respectively provided for the three windings. The series switch circuits each have an upper-side reverse conducting switching element that is a reverse conducting switching element connected between the high potential wire and the first connection terminal of the corresponding winding, and a lower-side reverse conducting switching element that is a reverse conducting switching element connected between the low potential wire and the first connection terminal of the corresponding winding. The first relay switch is provided between the high potential wire and the high potential charging terminal. The second relay switch is provided between the low potential wire and the low potential charging terminal. The third relay switch is provided between a positive electrode of the second battery and the neutral point. The control circuit can execute a charging operation of controlling the first relay switch, the second relay switch, and the third relay switch to be turned ON, controlling the three lower-side reverse conducting switching elements to be turned OFF, and continuously or intermittently turning ON a specified upper-side reverse conducting switching element that is at least one of the three upper-side reverse conducting switching elements in a state in which the high potential wire is connected to a positive electrode of the first battery and the low potential wire is connected to a negative electrode of the first battery and a negative electrode of the second battery when the first battery and the second battery are charged by the charging port. The control circuit turns OFF the specified upper-side reverse conducting switching element, then charges the first battery until OCV across the first battery becomes higher than OCV across the second battery, and then turns OFF the third relay switch when the charging operation is to be ended.

The second electric circuit turns OFF the specified upper-side reverse conducting switching element, then charges the first battery until OCV across the first battery becomes higher than OCV across the second battery, and then turns OFF the third relay switch when the charging operation is to be ended. According to this configuration, the deterioration of the third relay switch can be reduced.

### Embodiment 1

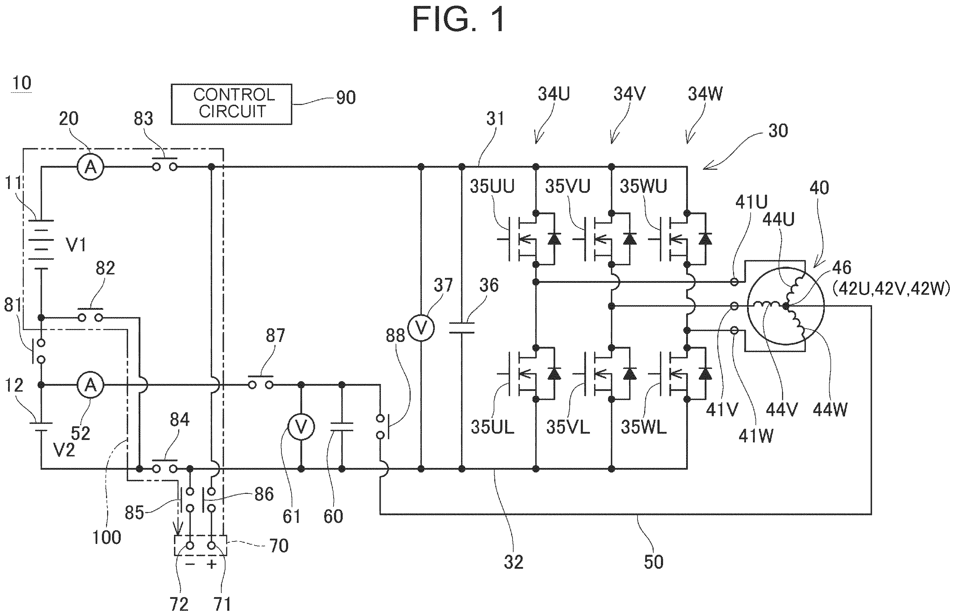

An electric circuit 10 shown in FIG. 1 is mounted on a vehicle. The electric circuit 10 has a first battery 11, a second battery 12, an inverter circuit 30, and a three-phase motor 40. The three-phase motor 40 is a traveling motor of the vehicle. The inverter circuit 30 converts DC electricity supplied from the first battery 11 and the second battery 12 to AC electricity and supplies the AC electricity to the three-phase motor 40. As a result, the three-phase motor 40 rotates driving wheels, and the vehicle travels.

The three-phase motor 40 has a U-phase winding 44U, a V-phase winding 44V, and a W-phase winding 44W. A terminal 41U and a terminal 42U are provided on both ends of the winding 44U. A terminal 41V and a terminal 42V are provided on both ends of the winding 44V. A terminal 41W and a terminal 42W are provided on both ends of the winding 44W. The terminals 42U, 42V, 42W are connected to each other at a neutral point 46.

The inverter circuit 30 is connected to the terminals 41U, 41V, 41W of the three-phase motor 40. The inverter circuit 30 has a high potential wire 31, a low potential wire 32, and three series switch circuits 34U, 34V, 34W. Each of the series switch circuits 34U, 34V, 34W is configured by two reverse conducting switching elements 35 connected in series between the high potential wire 31 and the low potential wire 32. Out of the two reverse conducting switching elements 35 connected in series, the reverse conducting switching element connected to the high potential wire 31 may be referred to as an upper-side reverse conducting switching element, and the reverse conducting switching element connected to the low potential wire 32 may be referred to as a lower-side reverse conducting switching element below. Each of the reverse conducting switching elements 35 has a structure in which a switching element (for example, an insulated gate bipolar transistor or a field effect transistor) and a diode (for example, a pn diode or a Schottky barrier diode) are connected in inverse-parallel with each other. In each of the reverse conducting switching elements 35, a cathode of the diode is connected to a high potential terminal (in other words, a collector or a drain) of the switching element, and an anode of the diode is connected to a low potential terminal (in other words, an emitter or a source) of the switching element.

The series switch circuit 34U is provided with respect to the winding 44U. The series switch circuit 34U has an upper-side reverse conducting switching element 35UU and a lower-side reverse conducting switching element 35UL. A high potential terminal of the upper-side reverse conducting switching element 35UU is connected to the high potential wire 31. A low potential terminal of the upper-side reverse conducting switching element 35UU and a high potential terminal of the lower-side reverse conducting switching element 3 5UL are connected to the terminal 41U. A low potential terminal of the lower-side reverse conducting switching element 35UL is connected to the low potential wire 32.

The series switch circuit 34V is provided with respect to the winding 44V. The series switch circuit 34V has an upper-side reverse conducting switching element 35VU and a lower-side reverse conducting switching element 35VL. A high potential terminal of the upper-side reverse conducting switching element 35VU is connected to the high potential wire 31. A low potential terminal of the upper-side reverse conducting switching element 35VU and a high potential terminal of the lower-side reverse conducting switching element 35VL are connected to the terminal 41V. A low potential terminal of the lower-side reverse conducting switching element 35VL is connected to the low potential wire 32.

The series switch circuit 34W is provided with respect to the winding 44W. The series switch circuit 34W has an upper-side reverse conducting switching element 35WU and a lower-side reverse conducting switching element 35WL. A high potential terminal of the upper-side reverse conducting switching element 35WU is connected to the high potential wire 31. A low potential terminal of the upper-side reverse conducting switching element 35WU and a high potential terminal of the lower-side reverse conducting switching element 35WL are connected to the terminal 41W. A low potential terminal of the lower-side reverse conducting switching element 35WL is connected to the low potential wire 32.

A capacitor 36 is connected between the high potential wire 31 and the low potential wire 32. A voltmeter 37 is connected between the high potential wire 31 and the low potential wire 32.

A neutral point wire 50 is connected to the neutral point 46 of the three-phase motor 40. The capacitor 60 is connected between the neutral point wire 50 and the low potential wire 32. A voltmeter 61 is connected between the neutral point wire 50 and the low potential wire 32.

The electric circuit 10 has a charging port 70. A connector of charging equipment outside the vehicle can be connected to the charging port 70. The charging port 70 has a high potential charging terminal 71 and a low potential charging terminal 72. When the connector of the charging equipment is connected to the charging port 70, DC voltage is applied to a place between the high potential charging terminal 71 and the low potential charging terminal 72 by the charging equipment in a direction in which the high potential charging terminal 71 becomes a high potential.

The electric circuit 10 has a plurality of relay switches 81 to 88. When each relay switch is switched, a mutual connection relationship between the first battery 11, the second battery 12, the high potential wire 31, the low potential wire 32, the neutral point 46, and the charging port 70 is changed.

The relay switch 81 is provided between a negative electrode of the first battery 11 and a positive electrode of the second battery 12. When the relay switch 81 is turned ON, the first battery 11 and the second battery 12 are connected to each other in series.

The relay switch 82 is provided between the negative electrode of the first battery 11 and a negative electrode of the second battery 12. When the relay switch 82 is turned ON, the negative electrode of the first battery 11 and the negative electrode of the second battery 12 are connected to each other.

An ammeter 20 and a relay switch 83 are provided in series between a positive electrode of the first battery 11 and the high potential wire 31. When the relay switch 83 is turned ON, the positive electrode of the first battery 11 is connected to the high potential wire 31.

The relay switch 84 is provided between the negative electrode of the second battery 12 and the low potential wire 32. When the relay switch 84 is turned ON, the negative electrode of the second battery 12 connected to the low potential wire 32.

The relay switch 85 is provided between the low potential charging terminal 72 and the low potential wire 32. When the relay switch 85 is turned ON, the low potential charging terminal 72 is connected to the low potential wire 32.

The relay switch 86 is provided between the high potential charging terminal 71 and the high potential wire 31. When the relay switch 86 is turned ON, the high potential charging terminal 71 is connected to the high potential wire 31.

An ammeter 52 and a relay switch 87 are provided in series between the positive electrode of the second battery 12 and the neutral point wire 50. The relay switch 88 is provided in the neutral point wire 50. When the relay switches 87, 88 are turned ON, the positive electrode of the second battery 12 is connected to the neutral point 46.

The electric circuit 10 has a control circuit 90. The control circuit 90 is configured by a CPU, a memory, and the like. A program that controls the electric circuit 10 is stored in the memory of the control circuit 90. The control circuit 90 controls the switching element of each reverse conducting switching element 35 and the relay switches 81 to 88 in accordance with the program. The control circuit 90 can execute a normal operation and a charging operation.

In the normal operation, the control circuit 90 turns ON the relay switches 81, 83, 84 and turns OFF the relay switches 82, 85, 86, 87, 88. In this state, the first battery 11 and the second battery 12 are connected in series between the high potential wire 31 and the low potential wire 32. Therefore, DC voltage output by the series circuit of the first battery 11 and the second battery 12 is applied to a place between the high potential wire 31 and the low potential wire 32. The control circuit 90 converts the DC electricity applied to a place between the high potential wire 31 and the low potential wire 32 to AC electricity and supplies the AC electricity to the three-phase motor 40 by switching the switching element of each reverse conducting switching element 35. As a result, the three-phase motor 40 rotates. The control circuit 90 controls the torque and the rotation speed of the three-phase motor 40 by changing the amplitude, the frequency, and the like of the AC supplied to the three-phase motor 40.

In the charging operation, the control circuit 90 performs charging of the first battery 11 and the second battery 12 by executing a charging program. When the connector of the external charging equipment is connected to the charging port 70, the control circuit 90 starts the charging operation. In the charging operation, the control circuit 90 turns ON the relay switches 82, 83, 84, 85, 86, 87, 88 and turns OFF the relay switch 81. In the charging operation, the first battery 11 and the second battery 12 are charged in parallel.

An arrow 100 in FIG. 1 indicates a charging route for the first battery 11. In the charging operation, the positive electrode of the first battery 11 is connected to the high potential charging terminal 71 via the relay switches 83, 86, and the negative electrode of the first battery 11 is connected to the low potential charging terminal 72 via the relay switches 82, 84, 85. Therefore, voltage (hereinafter referred to as charging equipment supplying voltage) supplied from the external charging equipment is applied to the first battery 11, and charging current flows to the first battery 11 by the route shown by the arrow 100 in FIG. 1. As a result, the first battery 11 is charged.

In the charging operation, the high potential wire 31 is connected to the high potential charging terminal 71 via the relay switch 86, and the low potential wire 32 is connected to the low potential charging terminal 72 via the relay switch 85. The positive electrode of the second battery 12 is connected to the neutral point 46 via the relay switches 87, 88, and the negative electrode of the second battery 12 is connected to the low potential charging terminal 72 and the low potential wire 32 via the relay switches 84, 85. In the charging operation, the control circuit 90 turns OFF lower-side reverse conducting switching elements 35UL, 35VL, and 35WL. In a state in which each unit is controlled as above, the control circuit 90 executes the charging of the second battery 12 by controlling at least one (hereinafter referred to as a specified upper-side switching element) of the upper-side reverse conducting switching elements 35UU, 35VU, 35WU. When elements other than the specified upper-side switching element out of the upper-side reverse conducting switching elements 35UU, 35VU, 35WU are present, the control circuit 90 maintains the elements other than the specified upper-side switching element to be turned OFF.

In the charging operation, the control circuit 90 can execute a direct charging operation and a step-down charging operation for the second battery 12.

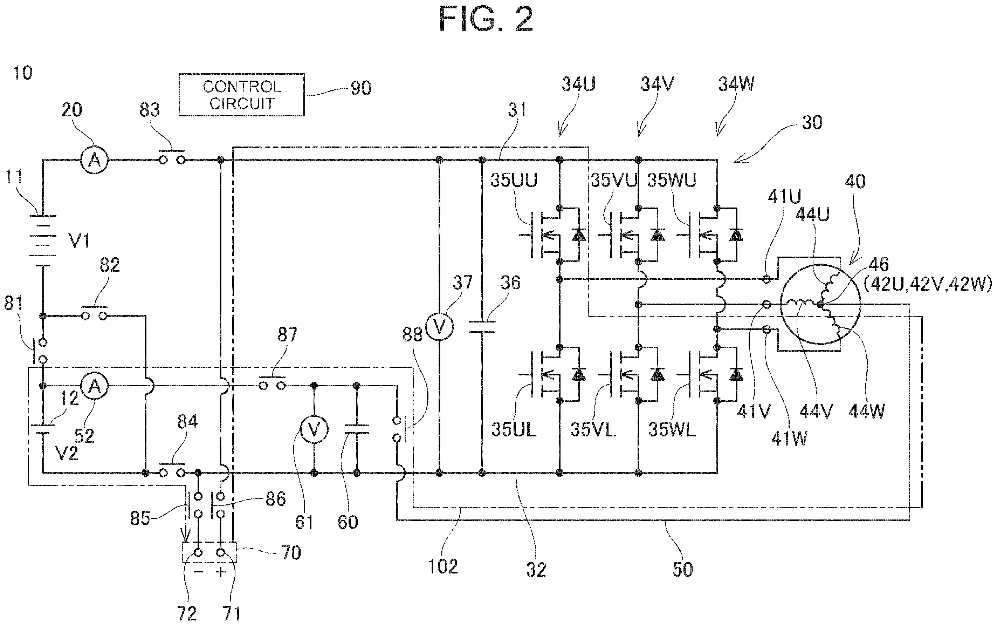

In the direct charging operation, the control circuit 90 maintains the specified upper-side switching element to be turned ON (in other words, turns the specified upper-side switching element to be continuously ON). An arrow 102 in FIG. 2 indicates a current route when the upper-side reverse conducting switching element 35VU is turned ON as the specified upper-side switching element. When the upper-side reverse conducting switching element 35VU is turned ON, the positive electrode of the second battery 12 is connected to the high potential charging terminal 71 via the relay switches 87, 88, the neutral point 46, the winding 44V, the upper-side reverse conducting switching element 35VU, the high potential wire 31, and the relay switch 86. Therefore, the charging equipment supplying voltage is applied to the second battery 12. As a result, the charging current flows by the route indicated by the arrow 102, and the second battery 12 is charged.

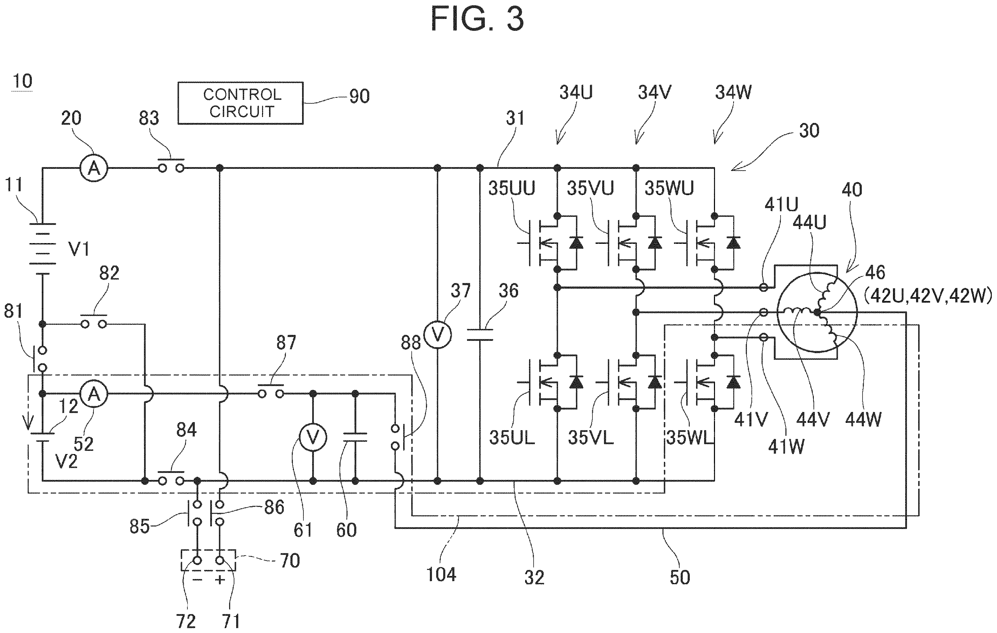

In the step-down charging operation, the control circuit 90 periodically switches the specified upper-side switching element (in other words, intermittently turns the specified upper-side switching element ON). The arrows 102 and 104 in FIGS. 2, 3 exemplify the current routes when the upper-side reverse conducting switching element 35VU is the specified upper-side switching element as the current route of the step-down charging operation. When the upper-side reverse conducting switching element 35VU is turned ON, the charging current flows as indicated by the arrow 102 in FIG. 2. When the upper-side reverse conducting switching element 35VU is turned OFF thereafter, induced electromotive voltage is generated in the winding 44V. As a result, as indicated by the arrow 104 in FIG. 3, a return current flows via a diode of the lower-side reverse conducting switching element 35VL, the winding 44V, and the second battery 12. In the step-down charging operation, the second battery 12 is charged as a result of the current alternately flowing through the routes indicated by the arrows 100, 102. As above, in the step-down operation, the inverter circuit 30 and the winding of the three-phase motor 40 function as a step-down converter circuit. Therefore, voltage lower than the charging equipment supplying voltage is applied to the second battery 12, and the second battery 12 is charged by a low charging current.

As described above, in the charging operation, the first battery 11 is charged by the route indicated by the arrow 100, and the second battery 12 is charged by the direct charging operation or the step-down charging operation. In other words, the first battery 11 and the second battery 12 are charged in parallel. It is also possible for the control circuit 90 to be configured to execute only one of the direct charging operation and the step-down charging operation.

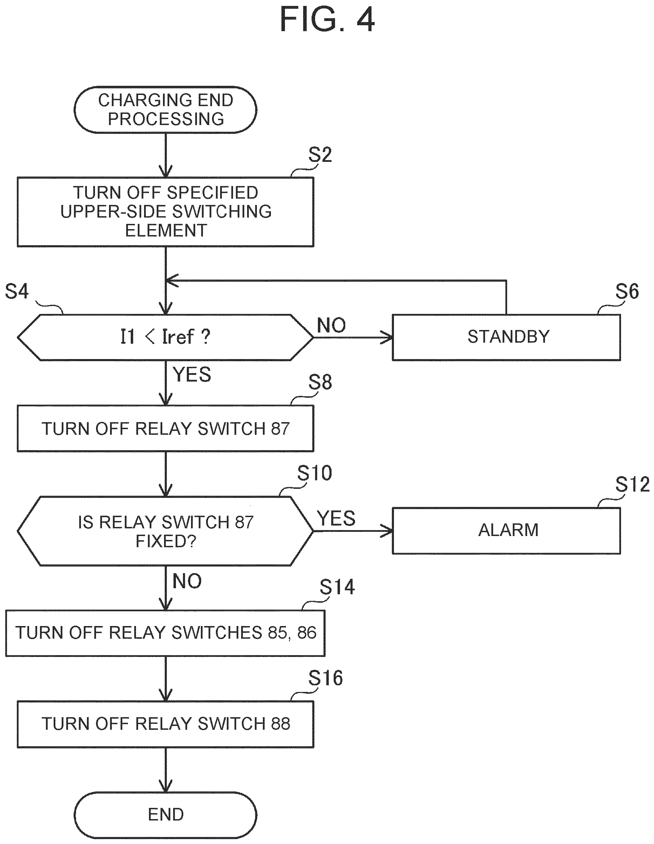

The control circuit 90 executes the charging end processing shown in FIG. 4 in accordance with a charging end program when the charging operation is ended. The charging end processing is executed when the first battery 11 and the second battery 12 are fully charged or a predetermined amount of time elapses from the start of the charging operation.

In Step S2, the control circuit 90 turns OFF the specified upper-side switching element. As a result, a state in which all of the reverse conducting switching elements are turned OFF is obtained. When all of the reverse conducting switching elements are turned OFF, the application of the charging equipment supplying voltage to the second battery 12 is stopped. In this phase, as shown in FIG. 1, the charging equipment supplying voltage is applied to the first battery 11.

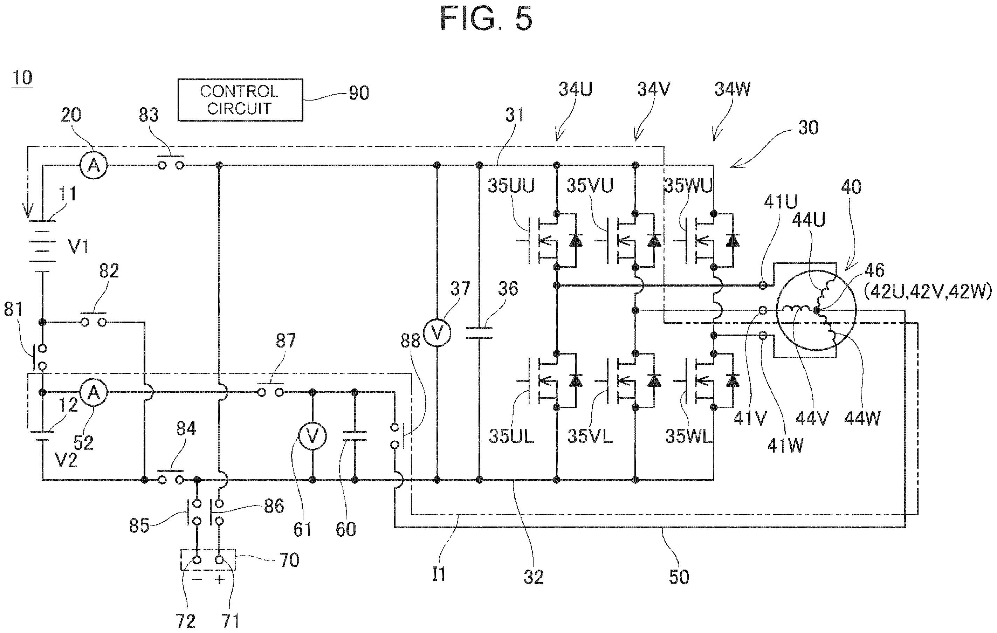

A leakage current I1 flows from the second battery 12 to the first battery 11 as shown in FIG. 5 when voltage V2 across both ends of the second battery 12 is higher than voltage V1 across both ends of the first battery 11 in a state in which all of the reverse conducting switching elements are turned OFF. The leakage current I1 flows from the positive electrode of the second battery 12 to the positive electrode of the first battery 11 via the neutral point 46, the diodes of upper-side reverse conducting switching elements 35U, 35VU, 35WU, and the high potential wire 31. In FIG. 5, as an example, a route passing through the diode of the upper-side reverse conducting switching element 35VU is shown. Meanwhile, the leakage current I1 does not flow when the voltage V2 across the second battery 12 is lower than the voltage V1 across the first battery 11. When the relay switch 87 is to be turned OFF in a state in which the leakage current I1 is flowing, fixation may occur at a contact point of the relay switch 87, and the relay switch 87 may not be able to be turned OFF.

In Step S4, the control circuit 90 detects the leakage current I1 by the ammeter 20 or 52 and determines whether the leakage current I1 is smaller than a reference value Iref. The reference value Iref is a current at a level at which the fixation of the relay switch does not occur and is a value at which the leakage current I1 can be considered to be zero. When the leakage current I1 is equal to or more than the reference value Iref, the control circuit 90 stands by for a predetermined amount of time in Step S6. The control circuit 90 repeats Steps S4, S6 until the leakage current I1 becomes smaller than the reference value Iref. During the standby of the control circuit 90, the leakage current I1 flows and the voltage V2 across the second battery 12 decreases. During the standby of the control circuit 90, the first battery 11 is charged and the voltage V1 rises. Therefore, the leakage current I1 gradually decreases during the standby of the control circuit 90. When the leakage current I1 becomes smaller than the reference value Iref, the control circuit 90 determines that Step S4 is YES and outputs an OFF signal to the relay switch 87 in Step S8. As a result, the relay switch 87 is turned OFF. The relay switch 87 can be turned OFF in a state in which the leakage current I1 is low, and hence the fixation of the relay switch 87 can be reduced.

Next, in Step S10, the control circuit 90 executes fixation determination processing of the relay switch 87. In the fixation determination processing, the control circuit 90 switches at least one of the upper-side reverse conducting switching elements 35UU, 35VU, 35WU, and monitors a current value detected by the ammeter 52. When the relay switch 87 is suitably turned OFF, the current value does not change in the fixation determination processing. Meanwhile, when the relay switch 87 has not been able to be turned OFF by fixation, the current value changes when the upper-side reverse conducting switching element is switched. When the control circuit 90 detects the fixation of the relay switch 87, the control circuit 90 causes the vehicle or the charging equipment to display an alarm in Step S12.

When the control circuit 90 does not detect the fixation of the relay switch 87 in Step S10, the control circuit 90 stops the charging current supplied from the charging equipment and turns OFF the relay switches 85, 86 in Step S14. Next, the control circuit 90 turns OFF the relay switch 88 in Step S16. As a result, the charging processing ends, and it becomes possible to remove the connector of the charging equipment from the charging port 70.

As described above, in Embodiment 1, the relay switch 87 is turned OFF after the leakage current I1 is stopped, and hence the fixation of the relay switch 87 can be reduced.

### Embodiment 2

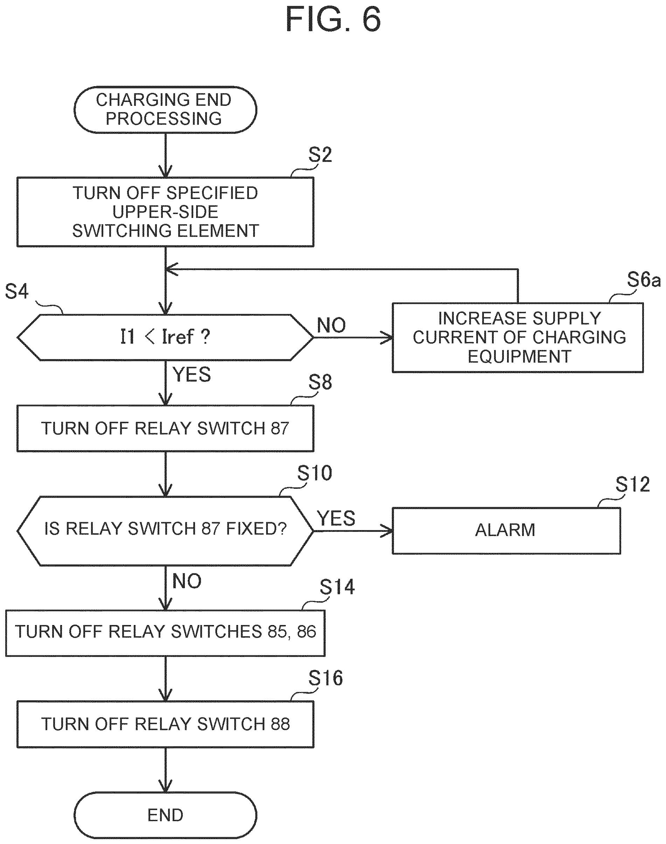

As shown in FIG. 6, in an electric circuit of Embodiment 2, Step S6a is executed in place of Step S6 of Embodiment 1. Other configurations of Embodiment 2 are equivalent to those of Embodiment 1.

In Embodiment 2, when it is determined that the leakage current I1 is equal to or more than the reference value Iref in Step S4, the control circuit 90 increases the supply current of the charging equipment (in other words, current supplied from the external charging equipment by the route indicated by the arrow 100 in FIG. 1) in Step S6a. When the supply current of the charging equipment increases, the potential of the high potential wire 31 rises, and the leakage current I1 decreases. The control circuit 90 repeats Steps S4, S6a until the leakage current I1 becomes smaller than the reference value Iref, and the control circuit 90 turns OFF the relay switch 87 in Step S8 when the leakage current I1 becomes smaller than the reference value Iref. As a result, the fixation of the relay switch 87 can be prevented.

As described above, in Embodiment 2, the leakage current I1 is decreased by increasing the supply current of the charging equipment. According to this configuration, the leakage current I1 can be decreased by an amount of time shorter than that in Embodiment 1. Therefore, the charging end processing can be completed by a shorter amount of time.

### Embodiment 3

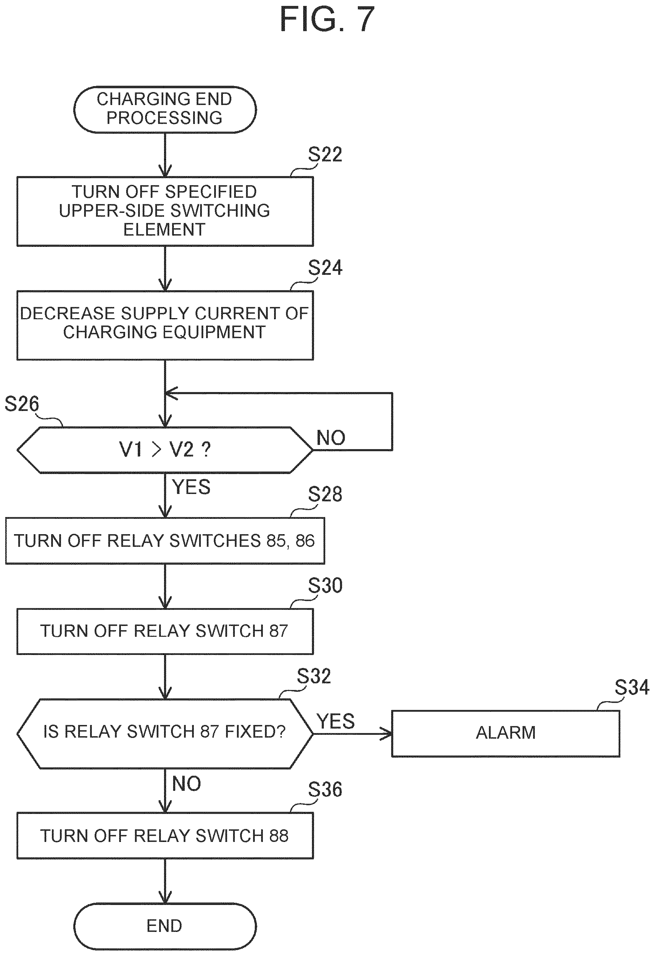

An electric circuit of Embodiment 3 executes charging end processing shown in FIG. 7. Other configurations of Embodiment 3 are equivalent to those of Embodiment 1.

In Step S22 the control circuit 90 turns OFF the specified upper-side switching element. As a result, a state in which all of the reverse conducting switching elements are turned OFF is obtained. When all of the reverse conducting switching elements are turned OFF, the application of the charging equipment supplying voltage to the second battery 12 is stopped. In this phase, the charging equipment supplying voltage is applied to the first battery 11.

Next, in Step S24, the control circuit 90 decreases the supply current of the charging equipment (in other words, the current supplied from the external charging equipment by the route indicated by the arrow 100 in FIG. 1) by giving a command to the external charging equipment. As a result, the charging current with respect to the first battery 11 decreases.

After the execution of Steps S22, S24, the control circuit 90 determines whether the voltage V1 across both ends of the first battery 11 (in other words, closed circuit voltage (CCV) across the first battery 11) is higher than the voltage V2 across both ends of the second battery 12 (in other words, open circuit voltage (OCV) across the second battery 12) in Step S26. When the voltage V2 is higher than the voltage V1, the leakage current I1 flows as shown in FIG. 5. The supply current of the charging equipment is decreased, and hence the CCV is substantially equal to the OCV in the first battery 11. Therefore, the determination in Step S26 is equivalent to determining whether the OCV across the first battery is higher than the OCV across the second battery. The voltage V2 can be detected by the voltmeter 61. The voltage V1 can be detected by subtracting the detection value of the voltmeter 61 from the detection value of the voltmeter 37. The control circuit 90 can detect the voltage V1, V2 and execute the determination in Step S26 on the basis of those detection values. As described above, the leakage current I1 flows when the voltage V2 is higher than the voltage V1. Therefore, the control circuit 90 may execute the determination in Step S26 by determining whether the leakage current I1 is flowing.

The control circuit 90 repeatedly executes Step S26 during the charging of the first battery 11. When the voltage V1 becomes higher than the voltage V2 by the charging of the first battery, the control circuit 90 executes Step S28.

In Step S28, the control circuit 90 turns OFF the relay switches 85, 86. As a result, the charging of the first battery 11 ends. As described above, the first battery 11 is charged to a state in which the OCV across the first battery 11 is higher than the OCV across the second battery, and hence the state in which the voltage V1 is higher than the voltage V2 is maintained even after the relay switches 85, 86 are turned OFF. Therefore, the leakage current I1 does not flow in Step S28 and thereafter either.

In Step S30, the control circuit 90 turns OFF the relay switch 87. The leakage current I1 is not flowing, and hence the fixation of the relay switch 87 can be prevented when the relay switch 87 is turned OFF.

In Step S32, the control circuit 90 executes the fixation determination processing of the relay switch 87 as with Step S10 in FIG. 4. When the control circuit 90 detects the fixation of the relay switch 87, the control circuit 90 causes the vehicle or the charging equipment to display an alarm in Step S34. When the relay switch 87 is not fixed, the control circuit 90 turns OFF the relay switch 88 in Step S36 and completes the charging end processing. As a result, it becomes possible to remove the connector of the charging equipment from the charging port 70.

As described above, in Embodiment 3, the charging of the first battery 11 is performed such that the OCV across the first battery 11 becomes higher than the OCV across the second battery 12. Therefore, the relay switch 87 can be turned OFF in a state in which the leakage current I1 is not flowing, and the fixation of the relay switch 87 can be prevented.

In Embodiment 3, the relay switch 87 may be turned OFF before the relay switches 85, 86.

The embodiments have been described in detail above, but those are merely exemplifications and do not limit the scope of claims. The technology described in the scope of claims includes those obtained by variously modifying and changing the specific examples exemplified above. The technical elements described in the present specification or the drawings exhibit a technical utility by itself or various combinations, and are not limited to the combinations described in the claims as originally filed. The technology exemplified in the present specification or the drawings achieves a plurality of objects at the same time, and has a technical utility by achievement of one of those objects itself.

## Claims

1. An electric circuit (10) mounted on a vehicle, the electric circuit (10) comprising:
a first battery (11);
a second battery (12);
a three-phase motor (40) having three windings that are a U-phase winding, a V-phase winding, and a W-phase winding, the three windings each having a first connection terminal provided on one end of the winding and a second connection terminal provided on another end of the winding, the second connection terminals of the three windings being connected to each other at a neutral point (46);
an inverter circuit (30) connected to the first connection terminal of the U-phase winding, the first connection terminal of the V-phase winding, and the first connection terminal of the W-phase winding and having a high potential wire (31), a low potential wire (32), and three series switch circuits respectively provided for the three windings, the three series switch circuits each having an upper-side reverse conducting switching element that is a reverse conducting switching element connected between the high potential wire (31) and the first connection terminal of the corresponding winding, and a lower-side reverse conducting switching element that is a reverse conducting switching element connected between the low potential wire (32) and the first connection terminal of the corresponding winding;
a charging port (70) having a high potential charging terminal and a low potential charging terminal and connected to charging equipment outside the vehicle;
a first relay switch (86) provided between the high potential wire (31) and the high potential charging terminal;
a second relay switch (85) provided between the low potential wire (32) and the low potential charging terminal;
a third relay switch (87) provided between a positive electrode of the second battery (12) and the neutral point (46); and
a control circuit (90) configured to:
execute a charging operation of controlling the first relay switch (86), the second relay switch (85), and the third relay switch (87) to be turned ON, controlling the three lower-side reverse conducting switching elements to be turned OFF, and continuously or intermittently turning ON a specified upper-side reverse conducting switching element that is at least one of the three upper-side reverse conducting switching elements in a state in which the high potential wire (31) is connected to a positive electrode of the first battery (11) and the low potential wire (32) is connected to a negative electrode of the first battery (11) and a negative electrode of the second battery (12) when the first battery (11) and the second battery (12) are charged by the charging port (70); and
turn OFF the third relay switch (87) and then turn OFF the first relay switch (86) and the second relay switch (85) when the charging operation is to be ended.

2. The electric circuit (10) according to claim 1, wherein the control circuit (90) is configured to turn OFF the specified upper-side reverse conducting switching element and then turn OFF the third relay switch (87) when the charging operation is to be ended.

3. The electric circuit (10) according to claim 2, wherein the control circuit (90) is configured to detect a leakage current that flows from the positive electrode of the second battery (12) to the positive electrode of the first battery (11) via the neutral point (46) after the specified upper-side reverse conducting switching element is turned OFF and to turn OFF the third relay switch (87) when the leakage current is smaller than a reference value.

4. The electric circuit (10) according to claim 2, wherein the control circuit (90) is configured to raise a current supplied from the charging equipment outside the vehicle to the charging port (70) until a leakage current that flows from the positive electrode of the second battery (12) to the positive electrode of the first battery (11) via the neutral point (46) becomes smaller than a reference value after the specified upper-side reverse conducting switching element is turned OFF, and to turn OFF the third relay switch (87) when the leakage current is smaller than the reference value.

5. The electric circuit (10) according to any one of claims 1 to 4, wherein the control circuit (90) is configured to execute fixation determination processing of detecting a current that flows to the second battery (12) in a state in which the specified upper-side reverse conducting switching element is turned ON and a state in which the specified upper-side reverse conducting switching element is turned OFF after a signal that turns OFF the third relay switch (87) is output.

6. A non-transitory storage medium storing instructions that are executable by one or more processors and that cause the one or more processors to perform functions comprising:
causing an electric circuit (10) mounted on a vehicle to execute charging processing, the electric circuit (10) having:
a first battery (11);
a second battery (12);
a three-phase motor (40) having three windings that are a U-phase winding, a V-phase winding, and a W-phase winding, the three windings each having a first connection terminal provided on one end of the winding and a second connection terminal provided on another end of the winding, the second connection terminals of the three windings being connected to each other at a neutral point (46);
an inverter circuit (30) connected to the first connection terminal of the U-phase winding, the first connection terminal of the V-phase winding, and the first connection terminal of the W-phase winding and having a high potential wire (31), a low potential wire (32), and three series switch circuits respectively provided for the three windings, the series switch circuits each having an upper-side reverse conducting switching element that is a reverse conducting switching element connected between the high potential wire (31) and the first connection terminal of the corresponding winding, and a lower-side reverse conducting switching element that is a reverse conducting switching element connected between the low potential wire (32) and the first connection terminal of the corresponding winding;
a charging port (70) having a high potential charging terminal and a low potential charging terminal and connected to charging equipment outside the vehicle;
a first relay switch (86) provided between the high potential wire (31) and the high potential charging terminal;
a second relay switch (85) provided between the low potential wire (32) and the low potential charging terminal;
a third relay switch (87) provided between a positive electrode of the second battery (12) and the neutral point (46); and
a control circuit (90);
causing the control circuit (90) to execute a charging operation, the charging operation being an operation of controlling the first relay switch (86), the second relay switch (85), and the third relay switch (87) to be turned ON, controlling the three lower-side reverse conducting switching elements to be turned OFF, and continuously or intermittently turning ON a specified upper-side reverse conducting switching element that is at least one of the three upper-side reverse conducting switching elements in a state in which the high potential wire (31) is connected to a positive electrode of the first battery (11) and the low potential wire (32) is connected to a negative electrode of the first battery (11) and a negative electrode of the second battery (12) when the first battery (11) and the second battery (12) are charged by the charging port (70); and
causing the control circuit (90) to turn OFF the third relay switch (87) and then to turn OFF the first relay switch (86) and the second relay switch (85) when the charging operation is to be ended.
